# EUROPEAN PATENT APPLICATION

(11) **EP 4 766 092 A1**
(43) Date of publication of application: **24.06.2026**
(21) Application number: 25184750.5
(22) Date of filing: 24.06.2025
(51) Int. Cl.: H10D 89/60, H02H 9/04

(54) **CIRCUIT STRUCTURE AND METHOD WITH A RESISTOR FOR REDUCING VOLTAGE AT CONTROL NODE FOR DEVICE**

(30) Priority: 20.12.2024 US 202418989080
(71) Applicant: GlobalFoundries U.S. Inc., Malta, NY 12020 (US)
(72) Inventor: Loiseau, Alain F., Essex Junction, 05452 (US); Subramani, Nandha Kumar, 01109 Dresden (DE)
(74) Representative: Grünecker Patent- und Rechtsanwälte PartG mbB

(57) **Abstract**

Embodiments of the disclosure provide a circuit structure and method with a resistor for reducing a discharged pad voltage. A structure of the disclosure includes a resistor having a first end connected to a pad and a second end opposite the first end. A trigger circuit is connected between the pad and ground. A discharge circuit is connected between the second end of the resistor and ground. The discharge circuit is connected to an output node of the trigger circuit.

## Description

### STATEMENT REGARDING FEDERAL RIGHTS

This invention was made with government support under Contract Number HQ0727790700, awarded by the United States Department of Defense. The government has certain rights in the invention.

### TECHNICAL FIELD

Embodiments of the disclosure relate generally to electronic circuits. More specifically, various embodiments of the disclosure provide a circuit structures and methods affecting a discharged pad voltage.

### BACKGROUND

Electric circuits, including integrated circuits (ICs), may include discharge elements for protecting the device hardware against events such as electrostatic discharge (ESD) voltages that can cause electrical shorts, dielectric breakdown, and/or other failure modes. In an ideal setting, ESD elements have no effect on the device operation until an ESD event is seen by a pin on an IC where the ESD event acts as a trigger voltage (or, in some cases, activates a trigger circuit to output a trigger voltage), which turns on the ESD devices and discharges current through the ESD element to power, or ground supply rails. ESD elements may serve no operational purpose until a trigger voltage is applied to the ESD element to activate it.

As device sizes continue to shrink, the operating parameters for discharge elements such as ESD protection circuits have become increasingly sensitive. For example, the discharge elements need to remain in an "off state" for all operations below a predetermined maximum operating voltage. However, the discharge element(s) need to become active above the predetermined maximum operating voltage but below the breakdown voltage level for the device. Conventional configurations for discharge elements have been unable to provide stable maximum operating voltages that are sufficiently below the breakdown voltage, potentially risking negative side effects to certain devices even where the discharge element(s) operate as intended.

### SUMMARY

Aspects of the present disclosure provide a structure including a resistor having a first end connected to a pad and a second end opposite the first end; a trigger circuit connected between the pad and ground; and a discharge circuit connected between the second end of the resistor and ground, wherein the discharge circuit is connected to an output node of the trigger circuit.

Further aspects of the present disclosure provide a structure including: a resistor having a first end coupled to an input/output (I/O) pad and a second end coupled to an device; a trigger circuit coupled between the I/O pad and a ground pad, and configured to output a trigger voltage in response to detecting a pad voltage on the I/O pad above a predetermined operating voltage; and a discharge circuit coupled between the second end of the resistor and the ground pad and configured to receive the trigger voltage from the trigger circuit, wherein the trigger voltage causes the discharge circuit to discharge an intermediate voltage from the second end of the resistor.

Additional aspects of the present disclosure provide a method including: coupling a first end of a resistor to an input/output (I/O) pad and a second end of the resistor to an device; outputting, from a trigger circuit coupled between the I/O pad and a ground pad, a trigger voltage in response to the trigger circuit detecting a pad voltage on the I/O pad above a predetermined operating voltage; and transmitting the trigger voltage to a discharge circuit coupled between the second end of the resistor and the ground pad and configured to receive the trigger voltage from the trigger circuit, wherein the trigger voltage causes the discharge circuit to discharge an intermediate voltage from the second end of the resistor.

### BRIEF DESCRIPTION OF THE DRAWINGS

These and other features of this disclosure will be more readily understood from the detailed description of the various aspects of the disclosure taken in conjunction with the accompanying drawings that depict various embodiments of the disclosure, in which:
FIG. 1 provides a schematic view of a circuit structure with a resistor for reducing pad voltage according to embodiments of the disclosure.
FIG. 2 provides an expanded schematic view of a circuit structure and device according to embodiments of the disclosure.
FIG. 3 shows a cross-sectional view of a high electron mobility transistor (HEMT) configured for implementation within a discharge circuit according to embodiments of the disclosure.
FIG. 4 provides a schematic view of a circuit structure with example implementations of a trigger circuit and discharge circuit according to embodiments of the disclosure.
FIG. 5 shows an illustrative plot of device voltage (V_{B}) versus pad voltage (V_{A}) during operation with different resistances according to embodiments of the disclosure.
FIG. 6 provides an illustrative flow diagram of methods for reducing pad voltage according to embodiments of the disclosure.

It is noted that the drawings of the disclosure are not necessarily to scale. The drawings are intended to depict typical aspects of the disclosure, and therefore should not be considered as limiting the scope of the disclosure. In the drawings, like numbering represents like elements between the drawings.

### DETAILED DESCRIPTION

In the description herein, reference is made to the accompanying drawings that form a part thereof, and in which is shown by way of illustration specific exemplary embodiments in which the present teachings may be practiced. These embodiments are described in sufficient detail to enable those skilled in the art to practice the present teachings, and it is to be understood that other embodiments may be used and that changes may be made within the scope of the present teachings. The description herein is, therefore, merely illustrative.

As device sizes continue to shrink, the operating parameters for discharge elements such as ESD protection circuits have become increasingly sensitive. For example, the discharge elements need to remain in an "off state" for all operations below a predetermined maximum operating voltage. However, the discharge element(s) need to become active above the predetermined maximum operating voltage but below the breakdown voltage level for the device. Conventional configurations for discharge elements have been unable to provide stable maximum operating voltages that are sufficiently below the breakdown voltage, potentially risking negative side effects to certain devices even where the discharge element(s) operate as intended.

Embodiments of the disclosure provide a circuit structure and method with a resistor for reducing the voltage at a control node for a device. A structure of the disclosure includes a resistor having a first end connected to a pad and a second end opposite the first end. A trigger circuit is connected between the pad and ground. A discharge circuit is connected between the second end of the resistor and ground. The discharge circuit is connected to an output node of the trigger circuit.

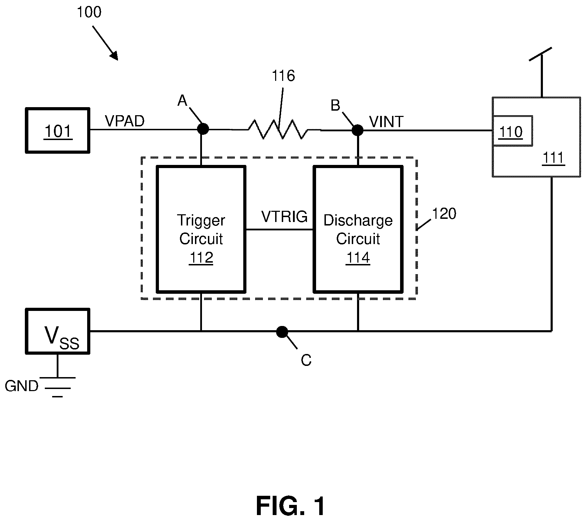

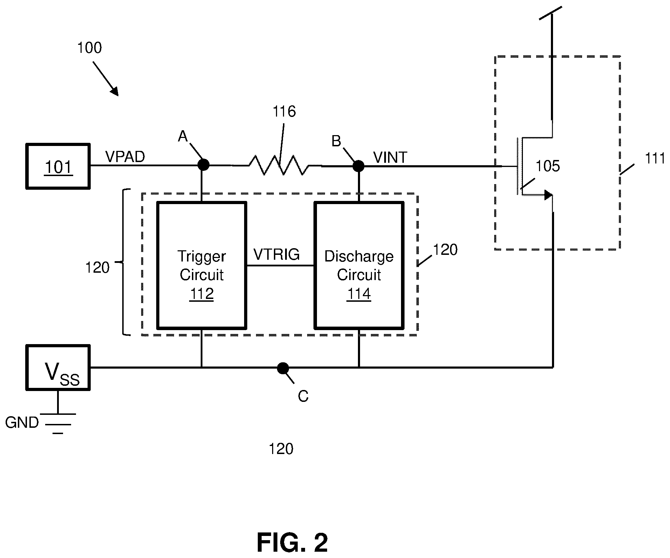

Referring to FIG. 1, a schematic view of a circuit structure (simply "structure" hereafter) 100 according to embodiments of the disclosure is shown. Structure 100 may be embodied as any type of electronic circuit and in various implementations may be provided in the form of, or included as part of, an integrated circuit (IC) structure. Structure 100 may include a pad 101. Pad 101 can be, for example, an input/output pad, a power pad, etc. at risk of suffering from a high voltage operating condition such as an electrostatic discharge (ESD) event. Pad 101 can further be electrically connected to a device 110 of an operational circuit 111 (e.g., a transceiver front-end or other circuit) for performing various functions. According to an example, as illustrated in FIG. 2, device 110 may be a transistor 105 (such as a "grounding transistor") or any other electrically controllable device configured to operate in response to signals from pad 101. Transistor 105 may have a first source/drain (S/D) terminal coupled to at least one other component of operational circuit 110, a second S/D terminal coupled to ground pad (GND, e.g., through terminal V_{SS}), and a gate coupled to pad 101. Structure 100 can be configured, as discussed in greater detail below, to protect device 110 from damage as a result of such an ESD event at pad 101.

A first node A of structure 100 is tied to pad 101. The gate (or alternatively, switching terminal) of device 110 is coupled to a second node B within structure 100. As discussed herein, one S/D terminal (or other input terminal) of device 110 is coupled other devices (not shown) within operational circuit 101 and the other S/D terminal (or output terminal) is coupled to ground GND at terminal V_{SS} through a third node C. Device 110 also may include a gate terminal (or other voltage-controlled node for enabling or disabling current flow through device 110) coupled to second node B. Device 110, although indicated as a single transistor (e.g., a protective transistor or grounding transistor as discussed herein), may be coupled to and/or may include more complex circuitry having several electrically active elements including several resistors, capacitors, diodes, and/or other devices. Additional components and/or circuitry may be coupled to structure 100 through input line Vᵢₙ, but the nature and operation of such components is immaterial to the configuration and operation of structure 100 and thus not discussed in further detail.

In the configuration shown, first node A may be set to the level of the input or "high voltage" input terminal of structure 100, and third node C may be set to the voltage level of the "ground" or "output" terminal of structure 100. Second node B may designate the junction between the gate terminal (or other control terminal) of device 110 and a discharge circuit 114 of structure 100, discussed in further detail herein. Second node B may be used to control the operation of device 110 but is susceptible to spikes in electrical current during an ESD event as discussed herein. Structure 100 is configured to react to excess charges and currents originating from an ESD event by creating an electrical short to bypass device 110, and simultaneously, reduce the voltage magnitude applied to device 110. During operation, resistor 116 of structure 100 reduces the voltage from an ESD event applied to the gate (or other control terminal) of device 110 ground (Vₛₛ) simultaneously with a trigger circuit 112 and discharge circuit 114 creating an intentional electrical short through structure 100.

Structure 100 may take the form of a clamp configured to create an electrical short from input pad 101 to ground through output terminal V_{SS} without decoupling device 110 from input pad 101. Structure 100 also may be configured to operate under non-ESD conditions with variations in voltage, e.g., by including a connection from input pad 101 to device 110 in operational circuit 111. Structure 100, however, includes additional components configured to be inactive during non-ESD scenarios or within predetermined voltage limits, so long as such voltage fluctuations are insufficient to trigger the transistor gate(s) of trigger circuit 112. Structure 100 thus is designed to create an electrical short circuit from input pad 101 to ground V_{SS} only upon detecting an ESD event.

A set of ESD elements 120 may couple first node A to the gate terminal (or other control terminal) of device 110 at second node B, and to ground terminal V_{SS} at third node C. ESD elements 120 may be selectively activated during an ESD event to create an electrical short from input pad 101 to ground terminal V_{SS} by responding to voltages or currents that are above a predetermined magnitude for device 110 and/or operational circuit 111 connected thereto. ESD element(s) 120 may be electrically inactive unless at least a predetermined voltage is applied to a trigger circuit 112 of ESD element(s) 120. In various other examples, additional circuitry and/or current paths may be located between device 110 and ESD element(s) 120, to further control the circumstances in which ESD elements 120 become electrically active.

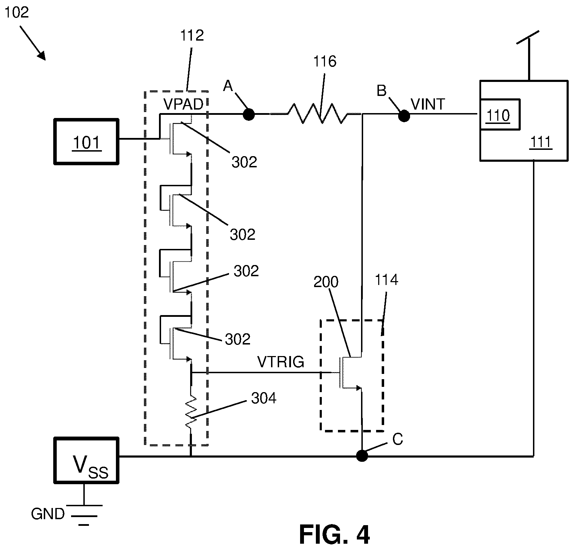

As discussed in further detail herein relative to FIG. 4, trigger circuit 112 of structure 100 may include several interconnected transistors, each configured to detect only a predetermined high voltage magnitude at pad 101, e.g., during an ESD event. A transistor refers to an electrical component in which a flow of current between input and output nodes (e.g., source and drain terminals) is controlled by the voltage applied to a third "gate" terminal. Trigger circuit 112 may include one or more transistors having a gate coupled to terminal A of structure 100, such that a voltage at pad 101 having a predetermined magnitude controls whether trigger circuit 112 is turned on or off. Trigger circuit 112 may be coupled at its output to discharge circuit 114. Trigger circuit 112, during operation, remains inactive until the predetermined operating voltage (e.g., an ESD voltage) is applied to trigger circuit 112 at node A from pad 101. Upon receiving the predetermined operating voltage, trigger circuit 112 outputs a trigger voltage (VTRIG) to discharge circuit 114 to enable protective interaction with device 110. Specifically, trigger circuit 112 will enable current flow through discharge circuit 114 to discharge the gate control terminal of device 110 to ground terminal V_{SS}.

Structure 100 includes resistor 116 with a first end coupled to pad 101 (at first node A) to receive a pad voltage (VPAD) and a second end coupled to discharge circuit 114 and the gate terminal of device 110 (at second node B). Resistor 116 is present in structure 100 to reduce VPAD received at the first end to an intermediate voltage (VINT) of lower magnitude output at the second end (e.g., to device 110, for example, as the gate voltage if device 110 is a transistor with a gate connected to pad 101). The reduction in voltage from first node A to second node B across resistor 116 occurs through application of Ohm's Law, as generally understood in relevant technical art. Discharge circuit 114, when activated by trigger circuit 112, selectively couples second node B (i.e., the second end of resistor 116) to ground (V_{SS}) at third node C. When discharge circuit 114 is inactive (i.e., no trigger voltage is applied thereto from trigger circuit 112), no current will travel from second node B to third node C via discharge circuit 114. In the case where trigger circuit 112 applies its trigger voltage to discharge circuit 114 (e.g., during an ESD event or other high voltage operating scenario at the predetermined operating voltage), discharge circuit 114 becomes active and creates an electrical short from second node B to third node C to ground (V_{SS}). Thus, during an ESD event or other high voltage operating scenario, the current path from pad 101 is from first node A to second node B through resistor 116 to the gate terminal of device 110, subsequently through discharge circuit 114 (due to the trigger voltage applied thereto from trigger circuit 112) to third node C, and to ground GND at terminal V_{SS}. Resistor 116 thus functions to reduce the voltage applied to the gate terminal of device 110 to an intermediate voltage level (VINT) that is less than the high voltage (VPAD) at pad 101.

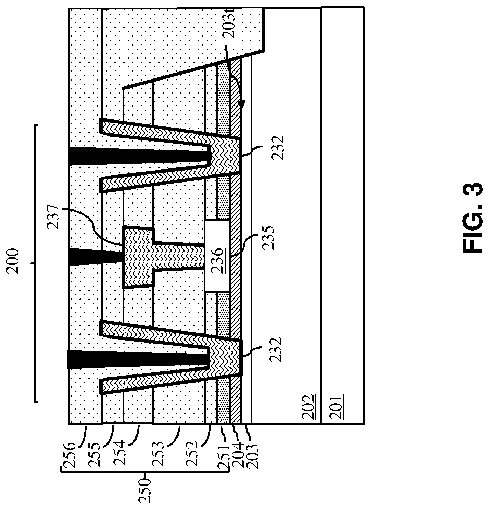

FIG. 3 provides an example of an high electron mobility transistor (HEMT) 200 that may be implemented within discharge element 114 of circuit 100. Conventionally, resistive elements in an ESD protective circuit create a risk of the ESD-detecting components not being triggered when a sufficiently high voltage occurs. The incorporation of resistor 116 into structure 100 may be achievable without such risks, in part, by HEMT device architectures within discharge element 114. It is emphasized that HEMT 200 as shown in FIG. 3 is an example of a particular device configuration; different devices having different polarities, doping profiles, electrical couplings, etc., may be substituted in discharge element 114 for embodiments of HEMT 200 as shown herein.

HEMT 200 may be provided using a stack of III-V semiconductor layers at essentially the same level above a substrate. More particularly, in the disclosed embodiments, the semiconductor structure can include a stack of III-V semiconductor layers. HEMT 200 thus may include any conceivable HEMT III-V semiconductor device built on such a structure, e.g., another HEMT enhancement-mode HEMT with or without raised III-V semiconductor source/drain regions, an enhancement-mode MISHEMT with or without raised III-V semiconductor source/drain regions, etc. As discussed herein, HEMT 200 may differ from other transistor architectures by including (among other components) a barrier layer above and immediately adjacent to a III-V semiconductor surface at the top of the stack in a first area. Various isolating materials (e.g., one or more isolation wells) may be within the stack adjacent to the III-V semiconductor surface, e.g., to electrically isolate HEMT 200 from other transistors having different architectures.

FIG. 3 provides a cross-section diagram illustrating an example implementation of HEMT 200. HEMT 200 can include a substrate 201. Substrate 201 can be, for example, a silicon substrate or a silicon-based substrate (e.g., a silicon carbide or silicon germanium substrate), a sapphire substrate, a III-V semiconductor substrate (e.g., a gallium nitride substrate or other suitable III-V semiconductor substrate) or any other substrate suitable for III-V semiconductor processing. HEMT 200 can include a stack of III-V semiconductor layers on substrate 201. Those skilled in the art will recognize that a III-V semiconductor refers to a compound obtained by combining one or more group III elements, such as boron (B), aluminum (Al), gallium (Ga), or indium (In), with one or more group V elements, such as nitrogen (N), phosphorous (P), arsenic (As) or antimony (Sb)). Thus, examples of III-V semiconductors include, but are not limited to, gallium nitride, indium phosphide, gallium arsenide, aluminum gallium nitride, indium gallium nitride, etc. The III-V semiconductor layers of the stack can be epitaxially grown on substrate 201 and can include at least a buffer layer 202 and a channel layer 203 on the buffer layer 202. For example, a buffer layer 202 can be above and immediately adjacent to the top surface of substrate 201. Buffer layer 202 can be employed as an anchor to achieve nucleation and to duplicate orientation in subsequently grown epitaxial layers. Buffer layer 202 could be, for example, a gallium nitride layer and/or one or more layers of any other III-V semiconductor(s) suitable for use as a buffer layer for a HEMT or metal-insulator-semiconductor HEMT (MISHEMT). Optionally, buffer layer 202 can be carbon-doped or iron-doped. Channel layer 203 can be above and immediately adjacent to the top surface of buffer layer 202. Channel layer 203 could be, for example, a gallium nitride layer and/or one or more layers of any other III-V semiconductor(s) suitable for use as a channel layer of a HEMT or MISHEMT. In any case, the top surface of the stack and, particularly, the top surface of channel layer 203 can be a III-V semiconductor surface 203t.

HEMT 200 can include, among other components discussed in greater detail below, a barrier layer 204 (and, particularly, another III-V semiconductor layer) that is above and immediately adjacent to III-V semiconductor surface 203t. HEMT 200 can further around and/or above various components of HEMT 200. The DM layers 250 can include a first DM layer 251 and, particularly, a silicon nitride layer. The DM layers can optionally include, but are not limited to, one or more of a second DM layer 252, a third DM layer 253, a fourth DM layer 254, a fifth DM layer 255, and a sixth DM layer 256. Any of the DM layers 252-156 can include a single layer of DM (e.g., a silicon dioxide layer or some other suitable DM) or two or more sub-layers of DM (e.g., a conformal silicon nitride layer and a silicon dioxide layer on the conformal silicon nitride layer or some other suitable combination of dielectric material layers).

HEMT 200 additionally includes source/drain terminals 232 on channel layer 203, and a gate terminal 235 on barrier layer 204 positioned laterally between source/drain terminals 232. HEMT 200 can include barrier layer 204 above and immediately adjacent to the III-V semiconductor surface 203t at the top of the stack. Barrier layer 204 can be yet another III-V semiconductor, which is different from channel layer 203 and which has a band gap that is wider than the bandgap of channel layer 203. Those skilled in the art will recognize that the channel and barrier III-V semiconductor materials can be selected so that a heterojunction is formed at the interface between the two layers, thereby resulting in the formation of a two-dimensional electron gas (2DEG) in channel layer 203. This 2DEG in channel layer 203 can provide the conductive pathway for the drifting of charges between source/drain terminals. The minimum voltage magnitude at gate terminal 235 to produce a 2DEG in channel layer 203 is also known as a "threshold voltage" in the case of an E-mode HEMT. Barrier layer 204 could be a layer of aluminum gallium nitride, aluminum nitride or any other III-V semiconductor material suitable for use as a barrier layer (e.g., depending upon the III-V semiconductor material of channel layer 203). In any case, the above-mentioned layers can be epitaxially grown by metal-organic chemical vapor deposition (MOCVD) or any other suitable technique (e.g., molecular beam epitaxy (MBE), hydride vapor phase epitaxy (HVPE), etc.). For purposes of illustration, the figures and the description above depict barrier layer 204 as including a single layer of III-V semiconductor material. However, it should be understood that the figures and description are not intended to be limiting and that, alternatively, barrier layer 204 could include two or more sub-layers of III-V semiconductor materials. First DM layer 251 (which as mentioned above can be a silicon nitride layer) can be above and immediately adjacent to the top surface of barrier layer 204.

HEMT 200 may be configured as an enhancement-mode (E-mode) HEMT. Those skilled in the art will recognize that an E-mode HEMT refers to a HEMT that remains in an "off" (i.e., non-conductive) state when no voltage is applied to its gate. In this case, HEMT 200 may require a threshold voltage to be applied to gate terminal 235 (e.g., a trigger voltage (VTRIG) from trigger circuit 112 (FIG. 1) as discussed herein) to operate to an on-state (i.e., to become conductive). In the case of an E-mode HEMT, HEMT 200 includes a P-type III-V semiconductor layer 236 in gate terminal 235 stacked between barrier layer 204 and gate conductor material 237. P-type III-V semiconductor layer 236 can be, for example, a III-V semiconductor (such as gallium nitride), which is epitaxially grown on barrier layer 204 and which is doped (e.g., with magnesium) so as to have P-type conductivity. In these implementations of HEMT 200, gate conductor material 237 can include metallic gate conductor material(s) so that gate terminal 235 is a Schottky contact gate terminal.

Referring now to FIG. 4, another schematic diagram of structure 100 is shown with example subcomponents for implementing trigger circuit 112 and discharge circuit 114. Discharge circuit 114, in some implementations, simply may include HEMT 200 coupled from drain to source from second node B to third node C, and at its gate to the source terminal at one end of serially coupled connected transistors 302 within trigger circuit 112. As discussed herein, HEMT 200 may be an E-mode HEMT such that current only flows there through from second node B to third node C concurrently with a trigger voltage applied to the gate of HEMT 200. In various alternative configurations, multiple interconnected HEMTs 200 may be included in discharge circuit 114, e.g., an array of interconnected HEMTs configured to function as a larger transistor according to any currently known or later developed "macro transistor" configuration, and/or other sets of interconnected transistors configured to approximate the function(s) of HEMT 200.

Trigger circuit 112, in contrast to discharge circuit 114, may include several conventional (e.g., non-HEMT) transistors interconnected together as a plurality of diode-connected transistors 302. A diode-connected transistor refers to a transistor configuration in which the control terminal of a transistor is coupled directly to one of its input-output terminals, thus converting the transistor into a two terminal diode structure. In the case of a metal oxide semiconductor field effect transistor (MOSFET), a diode-connected transistor may feature a drain (or alternatively, source) terminal tied to its gate. According to an example, trigger circuit 112 may include a first diode-connected transistor 302 with connected gate and drain terminals coupled to first node A and pad 101, a last diode-connected transistor coupled to one terminal of an additional resistor 304, and several intermediate diode-connected transistors 302 (e.g., two shown) connected to each other in series from drain to source between the first and last diode-connected transistors 302. Multiple diode-connected transistors 302 may be implemented in trigger circuit 112 instead of a single transistor, e.g., to reduce current leakage through trigger circuit 112 when discharge circuit 114 is not operating (i.e., when high voltage scenarios at the predetermined operating voltage, such as ESD events, are not occurring).

A junction between source of one diode-connected transistor 302 and one terminal of additional resistor 304 may be tied to the control terminal of discharge circuit 114 (e.g., the gate terminal of HEMT 200) such that the operative state of diode-connected transistors 302 determines whether a trigger voltage is applied to discharge circuit 114. Additional resistor 304 in trigger circuit 112 thus prevents the control terminal of discharge circuit 114 from being connected to ground at terminal V_{SS}. In alternative configurations, the control terminal of discharge circuit may be coupled to another node within trigger circuit 112, e.g., where different circuit configurations are used to perform similar functions. Diode-connected transistors 302 may have threshold voltages at a sufficiently high magnitude such that trigger circuit 112 will not operate until a predetermined high voltage magnitude is applied to structure 100 at pad 101. The threshold voltage for diode-connected transistors 302 in trigger circuit 112 may be at least equal to the anticipated voltage during an ESD event or similar event(s) with undesirably high voltage magnitudes. Due to the inclusion of resistor 116 between first node A and second node B, the voltage for activating trigger circuit 112 is larger than the actual voltage applied to the gate of device 110 and discharged therefrom through HEMT(s) 200 in discharge circuit 114. The combination of trigger circuit 112 (configured to trigger under higher pad voltage magnitudes than the breakdown voltage of device 110) with resistor 116 (configured to reduce the pad voltage to a lower magnitude than the breakdown voltage of device 110) allows structure 100 to discharge high voltage magnitudes via discharge circuit 114 without overwhelming the control terminal of device 110.

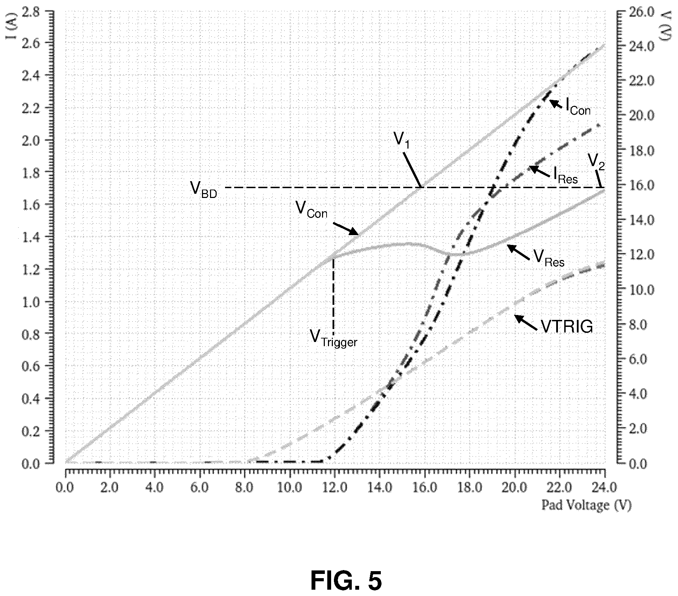

Referring to FIGS. 1 and 5 together, technical benefits of structure 100 are discussed in further detail relative to conventional protective circuit structures. FIG. 5 provides a comparative voltage plots and corresponding current plots for different amounts of electrical resistance for resistor 116 within structure 100. The left Y axis indicates the total current through structure 100 and the right Y axis indicates the voltage applied to device 110, i.e., the voltage at second node B. The X axis represents the input voltage applied at pad 101. The example plot of FIG. 5 thus indicates how changes in the pad voltage applied at first node A will affect control terminal voltages to device 110 at node B, as well as the ensuing currents through discharge circuit 114 when trigger circuit 112 activates. In a conventional ESD protective device without resistor 116 or similar resistive elements, there is essentially no resistance between nodes A and B and thus the conventional circuit, indicated with a dashed line, has a resistance "R" value of zero ohms (Ω).

In an example implementation of structure 100, indicated with a solid line, resistor 116 has a resistance of approximately four Ω. In the conventional case (V_{con}), rising pad voltages at first node A cause a linearly identical rise in voltage at second node B. This linearity is because, due to the absence of any resistive element between nodes A and B, the voltage applied to device 110 remains the same as the incoming voltage at pad 101. Thus, the voltage at second node B will reach the breakdown voltage (V_{BD}) at a magnitude V₁ that is only slightly higher than the trigger voltage (VTRIG) for trigger circuit 112. The breakdown voltage, when reached, may negatively affect device 110 even where ESD component 120 create an electrical short to ground at terminal V_{SS}. As indicated by the corresponding plot of current with no resistive element (I_{CON}) the output from trigger circuit 112 to discharge circuit 114 is the same regardless of whether resistor 116 is present. As the applied voltage from pad 101 increases (e.g., above 8V) so does the output voltage from trigger circuit 112 (VTRIG). However, if there is no resistor, the input pad voltage can only rise to 15 V (V₁) before device 110 reaches its breakdown voltage, and thus, the discharge current through discharge device (I_{CON})114 reaches its maximum at only approximately 0.5A.

For the trendline indicating the operating profile of structure 100 with resistor 116, there is substantially less risk of operating at breakdown voltage V_{BD} after reaching the predetermined voltage (V_{Trigger}), but essentially no difference during operation at voltages below trigger voltage V_{Trigger}. When the voltage at first node A is less than the predetermined voltage to activate trigger circuit 112, this same linear relationship in voltages is present because no voltage drop occurs across resistor 116 (i.e., second node B is connected only to the gate or control terminal of device 110). The voltage at first node A reaching V_{Trigger}, however, activates trigger circuit 112, and thereby activates discharge circuit 114 to cause a voltage drop across resistor 116. The relationship in voltage between nodes A and B may become piecewise-defined after discharge circuit 114 becomes active. Initially, as shown in FIG. 5, this may cause a slight decline in voltage between nodes A and B above the predetermined voltage due to the parallel current pathway across diode connected transistors 302. With resistor 116 present and having a resistance above zero (e.g., four Ω), the voltage at pad 101 (indicated by line V_{RES}) can increase to 23V (V₂) before device 110 fails. Thus, the discharge current through discharge circuit 114 (I_{RES}) in this configuration can reach a much higher level (e.g., 2 amperes in the example of FIG. 5). Thus, as shown, structure 100 is operable to apply an intermediate voltage at second node B that is less than the higher voltage magnitude at first node A for activating trigger circuit 112.

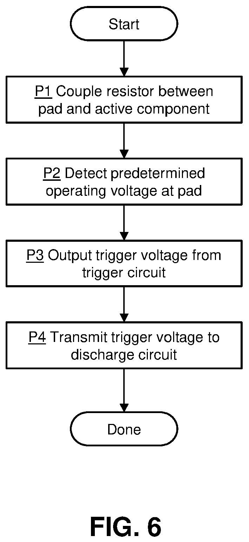

Referring now to FIGS. 1, 5, and 6 together, embodiments of the disclosure provide methods to operate structure 100 such that, during an ESD event or other high voltage operation, device 110 has an intermediate voltage at second node B that is less than the voltage at first node A for activating trigger circuit 112. Process P1 in methods of the disclosure may include coupling resistor 116 between pad 101 (at first node A) and device 110 (at second node B) in structure 100. Resistor 116 in this position is operable to create a voltage drop from first node A to second node B, and without disconnecting device 110 from pad 101, when trigger circuit 112 activates discharge circuit 114 to create a current pathway between pad 101 and ground (at terminal V_{SS}) through resistor 116. The coupling of resistor 116 between nodes A, B in process P1 thus may produce structure 100 as discussed herein.

An ESD event or other high voltage operation may create a sufficiently high voltage at first node A to activate trigger circuit 112, and thereby open a current pathway to third node C through discharge circuit 114. Process P2 in methods of the disclosure may include detecting the predetermined operating voltage at first node A, e.g., by activating trigger circuit 112 in response to at least a predetermined voltage magnitude being applied from input pad 101. The detecting in process P2 thus simply may include any process that applies a sufficient voltage to activate trigger circuit 112, e.g., applying at least a threshold voltage to a diode connected transistor 302 (FIG. 4) within trigger circuit 112.

The activating of trigger circuit 112, alone, may not create an electrical pathway from pad 101 to output pad V_{SS} through structure 100. In methods of the disclosure, process P3 may include causing trigger circuit 112 to output trigger voltage VTRIG to the control node(s) of discharge circuit 114. Where discharge circuit 114 includes one or more HEMTs 200 (FIGS, 3, 4), process P3 simply may include outputting a trigger voltage from discharge circuit 114 with a magnitude equal to, or greater than, a threshold voltage to the gate terminal of the E-mode HEMT(s) 200. Process P4 thus can include transmitting trigger voltage VTRIG to discharge circuit 114 in structure 100. As discussed herein, applying trigger voltage VTRIG to discharge circuit 114 (e.g., at HEMT(s) 200 thereof) will enable current to travel from drain to source from second node B (tied to the gate or control terminal of device 110) to third node C. Due to the presence of resistor 116 between first node A and second node B, the voltage drop across resistor 116 will cause device 110 at second node B to have an intermediate voltage that is less than the voltage at pad 101 (e.g., less than the high voltage created during an ESD event) to avoid negatively affecting device 110. These processes, when implemented, may protect device 110 and other circuitry of a device from being harmed by high voltage events, while simultaneously preventing device 110 from operating above its breakdown voltage due to the presence of resistor 116. These technical benefits and related advantages may be further pronounced in implementations where discharge circuit 114 includes HEMT 200 but trigger circuit 112 does not include any HEMT devices therein.

Embodiments of the disclosure may provide several technical and commercial advantages, some of which are discussed by example herein. Embodiments of structure 100 provide, e.g., a structure capable of responding to ESD events with conventional trigger voltage magnitudes, without applying voltages applied to device 110 that are near its breakdown voltage. Device 110 may remain coupled to pad 101 during such events, and have an intermediate voltage applied thereto, due to the inclusion of resistor 116. Embodiments of the disclosure, moreover, avoid the conventional penalties to size and performance associated with forming a resistor in an ESD protective circuit by using HEMTs or similar architectures to provide discharge pathways. These advantages, in turn may provide lower leakage currents regardless of the operating state of structure 100 and may provide greater protection against high voltage events by accommodating a wider range of voltages before the intermediate voltage approaches the breakdown voltage of device 110.

The descriptions of the various embodiments of the present disclosure have been presented for purposes of illustration, but are not intended to be exhaustive and/or limited to the embodiments disclosed. Many modifications and variations will be apparent to those of ordinary skill in the art within the scope and spirit of the described embodiments The terminology used herein was chosen to best explain the principles of the embodiments, the practical application and/or technical improvement over technologies found in the marketplace, and/or to enable others of ordinary skill in the art to understand the embodiments disclosed herein.

The following embodiments are explicitly disclosed:

### Embodiment 1:

A structure comprising:
a resistor having a first end coupled or connected to a pad and a second end opposite the first end;
a trigger circuit coupled or connected between the pad and ground; and
a discharge circuit coupled or connected between the second end of the resistor and ground. The discharge circuit may be coupled or connected to an output node of the trigger circuit.

### Embodiment 2:

The structure of embodiment 1, wherein the trigger circuit is configured to output a trigger voltage in response to detecting a pad voltage above a predetermined operating voltage.

### Embodiment 3:

The structure of embodiment 2, wherein the resistor reduces the pad voltage received from the pad at the first end to an intermediate voltage output from the second end, and wherein the discharge circuit is configured to receive the trigger voltage from the trigger circuit and, in response to the trigger voltage, discharge the intermediate voltage.

### Embodiment 4:

The structure of one of embodiments 1 to 3, wherein the discharge circuit includes an enhancement mode high electron mobility transistor (HEMT) having a gate coupled to the trigger circuit, a first source/drain (S/D) terminal coupled to the second end of the resistor, and a second S/D terminal coupled to the ground pad.

In some illustrative examples herein, embodiment 4 may be combined with embodiment 3.

### Embodiment 5:

The structure of one of embodiments 1 to 4, wherein the trigger circuit includes:
a plurality of diode-connected field effect transistors connected in series between the pad and the output node; and
an additional resistor connected between the output node and the ground pad, wherein the trigger voltage is generated and output at the output node.

In some illustrative examples herein, embodiment 5 may be combined with embodiment 2.

### Embodiment 6:

The structure of one of embodiments 1 to 5, wherein the discharge circuit includes a high electron mobility transistor (HEMT), and wherein the trigger circuit is free of HEMTs.

### Embodiment 7:

The structure of one of embodiments 1 to 6, wherein the predetermined operating voltage is greater than trigger voltage.

### Embodiment 8:

A structure comprising:
a resistor having a first end coupled to an input/output (I/O) pad and a second end coupled to a device, wherein the resistor decreases a pad voltage received from the I/O pad at the first end to a intermediate voltage output from the second end;
a trigger circuit coupled between the I/O pad and a ground pad, and configured to output a trigger voltage in response to detecting that the pad voltage on the I/O pad is above a predetermined operating voltage; and
a discharge circuit coupled between the second end of the resistor and the ground pad and configured to receive the trigger voltage from the trigger circuit and, in response to the trigger voltage, discharge the intermediate voltage.

In some illustrative examples of embodiment 8, the structure of embodiment 8 may be related to one of embodiments 1 to 7, wherein:
the first end of the resistor is coupled to an input/output (I/O) pad and the second end of the resistor is coupled to a device, the resistor decreasing a pad voltage received from the I/O pad at the first end to a intermediate voltage output from the second end;
the trigger circuit is coupled between the I/O pad and a ground pad, and the trigger circuit being configured to output a trigger voltage in response to detecting that the pad voltage on the I/O pad is above a predetermined operating voltage; and
the discharge circuit is coupled between the second end of the resistor and the ground pad, the discharge circuit being configured to receive the trigger voltage from the trigger circuit and, in response to the trigger voltage, discharge the intermediate voltage.

### Embodiment 9:

The structure of embodiment 8, wherein decreasing the pad voltage to the intermediate voltage enables concurrently increasing the trigger voltage output from the trigger circuit, avoiding damage to the device, and increasing the drive current of the discharge circuit.

### Embodiment 10:

The structure of embodiment 8 or 9, wherein the discharge circuit includes a high electron mobility transistor (HEMT) having a gate coupled to the trigger circuit, a first source/drain (S/D) terminal coupled to the second end of the resistor, and a second S/D terminal coupled to the ground pad.

### Embodiment 11:

The structure of embodiment 10, wherein the HEMT is an enhancement mode HEMT.

### Embodiment 12:

The structure of one of embodiments 8 to 11, wherein the trigger circuit includes:
an output node;
a plurality of diode-connected field effect transistors connected in series between the I/O pad and the output node; and
an additional resistor connected between the output node and the ground pad, wherein the trigger voltage is generated and output at the output node.

### Embodiment 13:

The structure of one of embodiments 8 to 12, wherein the discharge circuit includes a high electron mobility transistor (HEMT), and wherein the trigger circuit is free of HEMTs.

### Embodiment 14:

The structure of one of embodiments 8 to 13, wherein the predetermined operating voltage is greater than trigger voltage.

### Embodiment 15:

A method comprising:
decreasing, by a resistor, a pad voltage received at a first end from an input/output (I/O) pad and outputting, by the resistor, an intermediate volage lower than the pad voltage at a second end, wherein the second end of the resistor is coupled to an device;
outputting, by a trigger circuit coupled between the I/O pad and a ground pad, a trigger voltage in response to the trigger circuit detecting that the pad voltage on the I/O pad is above a predetermined operating voltage;
receiving, by a discharge circuit coupled between the second end of the resistor and the ground pad, the trigger voltage from the trigger circuit; and
discharging, by the discharge circuit, the intermediate voltage.

### Embodiment 16:

The method of embodiment 15, wherein the decreasing of the pad voltage to the intermediate voltage enables concurrently increasing the trigger voltage output from the trigger circuit, avoiding damage to the device, and increasing the drive current of the discharge circuit.

### Embodiment 17:

The method of embodiment 16, wherein the discharge circuit includes a high electron mobility transistor (HEMT) having a gate coupled to the trigger circuit, a first source/drain (S/D) terminal coupled to the second end of the resistor, and a second S/D terminal coupled to the ground pad.

### Embodiment 18:

The method of embodiment 17, wherein the HEMT is an enhancement mode HEMT.

### Embodiment 19:

The method of embodiment 18, wherein the trigger circuit is free of HEMTs.

### Embodiment 20:

The method of one of embodiments 15 to 19, wherein the predetermined operating voltage is greater than trigger voltage.

### Embodiment 21:

The method of one of embodiments 15 to 20, wherein the structure of one of embodiments 1 to 14 is operated.

In summary of the above embodiments, the disclosure provides a circuit structure and method with a resistor for reducing a discharged pad voltage. A structure of the disclosure includes a resistor having a first end connected to a pad and a second end opposite the first end. A trigger circuit is connected between the pad and ground. A discharge circuit is connected between the second end of the resistor and ground. The discharge circuit is connected to an output node of the trigger circuit.

## Claims

1. A structure comprising:
a resistor having a first end connected to a pad and a second end opposite the first end;
a trigger circuit connected between the pad and ground; and
a discharge circuit connected between the second end of the resistor and ground, wherein the discharge circuit is connected to an output node of the trigger circuit.

2. The structure of claim 1, wherein the trigger circuit is configured to output a trigger voltage in response to detecting a pad voltage above a predetermined operating voltage.

3. The structure of claim 2, wherein the resistor reduces the pad voltage received from the pad at the first end to an intermediate voltage output from the second end, and wherein the discharge circuit is configured to receive the trigger voltage from the trigger circuit and, in response to the trigger voltage, discharge the intermediate voltage.

4. The structure of one of claims 1 to 3, wherein the discharge circuit includes a high electron mobility transistor (HEMT), preferably an enhancement mode HEMT, the HEMT having a gate coupled to the trigger circuit, a first source/drain (S/D) terminal coupled to the second end of the resistor, and a second S/D terminal coupled to the ground pad.

5. The structure of one of claims 1 to 4, wherein the trigger circuit includes:
a plurality of diode-connected field effect transistors connected in series between the pad and the output node; and
an additional resistor connected between the output node and the ground pad, wherein the trigger voltage is generated and output at the output node,
wherein the trigger circuit preferably further comprises an output node.

6. The structure of one of claims 1 to 5, wherein the discharge circuit includes a high electron mobility transistor (HEMT), and wherein the trigger circuit is free of HEMTs.

7. The structure of one of claims 1 to 6, wherein the predetermined operating voltage is greater than trigger voltage.

8. The structure of one of claims 1 to 7, wherein:
the first end of the resistor is coupled to an input/output (I/O) pad and the second end of the resistor is coupled to a device, the resistor decreasing a pad voltage received from the I/O pad at the first end to a intermediate voltage output from the second end;
the trigger circuit is coupled between the I/O pad and a ground pad, and the trigger circuit being configured to output a trigger voltage in response to detecting that the pad voltage on the I/O pad is above a predetermined operating voltage; and
the discharge circuit is coupled between the second end of the resistor and the ground pad, the discharge circuit being configured to receive the trigger voltage from the trigger circuit and, in response to the trigger voltage, discharge the intermediate voltage.

9. The structure of claim 8, wherein decreasing the pad voltage to the intermediate voltage enables concurrently increasing the trigger voltage output from the trigger circuit, avoiding damage to the device, and increasing the drive current of the discharge circuit.

10. The structure of claim 8 or 9, wherein the trigger circuit includes:
an output node;
a plurality of diode-connected field effect transistors connected in series between the I/O pad and the output node; and
an additional resistor connected between the output node and the ground pad, wherein the trigger voltage is generated and output at the output node.

11. A method comprising:
decreasing, by a resistor, a pad voltage received at a first end from an input/output (I/O) pad and outputting, by the resistor, an intermediate volage lower than the pad voltage at a second end, wherein the second end of the resistor is coupled to an device;
outputting, by a trigger circuit coupled between the I/O pad and a ground pad, a trigger voltage in response to the trigger circuit detecting that the pad voltage on the I/O pad is above a predetermined operating voltage;
receiving, by a discharge circuit coupled between the second end of the resistor and the ground pad, the trigger voltage from the trigger circuit; and
discharging, by the discharge circuit, the intermediate voltage.

12. The method of claim 11, wherein the decreasing of the pad voltage to the intermediate voltage enables concurrently increasing the trigger voltage output from the trigger circuit, avoiding damage to the device, and increasing the drive current of the discharge circuit.

13. The method of claim 12, wherein the discharge circuit includes a high electron mobility transistor (HEMT) having a gate coupled to the trigger circuit, a first source/drain (S/D) terminal coupled to the second end of the resistor, and a second S/D terminal coupled to the ground pad.

14. The method of claim 13, wherein the HEMT is an enhancement mode HEMT, and/or wherein the trigger circuit is free of HEMTs.

15. The method of one of claims 11 to 14, wherein the predetermined operating voltage is greater than trigger voltage.
